# EUROPEAN PATENT APPLICATION

(11) **EP 4 641 598 A1**
(43) Date of publication of application: **29.10.2025**
(21) Application number: 24305622.3
(22) Date of filing: 23.04.2024
(51) Int. Cl.: H01G 4/33, H01G 4/08, H01G 4/012, H01G 4/005, H01G 4/008, H01G 4/12

(54) **AN ENERGY STORAGE COMPONENT COMPRISING A CAPACITOR OR AN IONIC CAPACITOR, WITH A BUFFER LAYER IN A PERIPHERAL REGION**

(71) Applicant: Murata Manufacturing Co., Ltd., Nagaokakyo-shi, Kyoto 617-8555 (JP); Commissariat à l'Energie Atomique et aux Energies Alternatives, 75015 Paris (FR)
(72) Inventor: BUFFLE, Larry, 38000 GRENOBLE (FR); SALLAZ, Valentin, 38000 GRENOBLE (FR); VOIRON, Frédéric, 38530 BARRAUX (FR); SALVADOR, Violaine, 38054 Grenoble cedex 09 (FR); OUKASSI, Sami, 38054 Grenoble cedex 09 (FR)
(74) Representative: Cabinet Beau de Loménie

(57) **Abstract**

An integrated electrical device comprising an energy storage component, the component comprising, above a support (100, 101, 103), a bottom electrode layer (105), an intermediate layer (107) comprising a dielectric layer or an ionic conductor layer above the bottom electrode layer, and a top electrode layer (108) above and on the intermediate layer,
wherein the intermediate layer is in contact with the bottom electrode layer and with the top electrode layer in a central region (CR), and the intermediate layer is are spaced apart from either the bottom electrode layer or the top electrode layer by a buffer layer (106) in a peripheral region (PR) that surrounds the central region, the buffer layer comprising an insulating material and being arranged on the bottom electrode layer or on the intermediate layer, the buffer layer having an opening that opens onto the bottom electrode layer or onto the intermediate layer so as to define the central region,
the intermediate layer and the top electrode layer being arranged conformally above the bottom electrode layer.

## Description

### Field of the Invention

The present invention relates to the field of integration and, more particularly, to electronic products comprising energy storage components such as capacitors or ionic capacitors, and their methods of manufacture.

### Technical Background

Various technologies have been developed for integrating passive components, such as energy storage components, capacitive devices, etc. in/on substrates such as silicon wafers.

There is a general desire to construct integrated energy storage components that provide a high energy storage density. Various approaches have been tried in this regard. In the case of capacitive devices, conventional approaches for increasing capacitance include reducing the thickness of the dielectric layer (subject to the constraint of avoiding dielectric breakdown when the operating voltage is applied) and selecting a material having high dielectric constant as the material of the dielectric layer.

More recently, proposals have been made to form the conductive layers and dielectric layer of an integrated energy storage component conformally over a contoured surface (i.e. forming the conductive layers and dielectric layer so that their shape conforms to the shape of the underlying surface) rather than employing planar layers. Energy storage components of this type may be referred to as "three-dimensional" components (to differentiate them from planar devices). As an example, the PICS technology proposed by Murata Integrated Passive Solutions employs three-dimensional capacitive components and allows high density capacitive components to be integrated into a silicon substrate.

Recently, three-dimensional capacitive components have been fabricated by embedding a Metal-Insulator-Metal (MIM) structure in a porous anodized material, for example in porous anodized alumina (PAA). This technology provides highly-integrated capacitance which can be used for many applications. This technology implements a capacitive stack (for example a MIM stack) in a porous structure which is formed above a substrate such as a silicon wafer. The porous structure may result from the anodization of a thin layer of aluminum deposited above the substrate (e.g. deposited on the substrate or deposited on one or more layers which are themselves formed on the substrate). The anodization process converts the AI into alumina, which is porous (PAA). A mask may optionally be formed over the aluminium layer before anodization takes place, so that the anodization process forms islands of porous material. These components, using a dielectric in the MIM stack, are referred to as capacitors in the present descriptions.

There also exist devices making use of ionic conductors having electronic insulating properties (called ionic conductors in the present application) between electrodes, referred to as ionic capacitors, the ionic conductors are solid-state electrolytes such as LiPON. These ionic capacitors may also be accommodated in a porous anodized alumina structure.

In particular, using solid state electrolytes has been reported to enable planar capacitance densities of around 200-500nF/mm². In such an ionic capacitor, energy is stored via accumulation of mobile charges (ions such as Li+, Na+, etc.) at the electrolyte/electrode interfaces through electrostatic and/or redox processes.

Also, these ionic capacitors may also be accommodated within the pores of a 3D structure so as to increase the capacitance density.

Forming (non-ionic) capacitors or ionic capacitors within the pores of anodic porous oxide, or inside other types of 3D structures, remains difficult to implement.

Usually, above an ionic or non-ionic capacitor formed above a support (for example a porous anodic oxide support), a conductive layer (typically Aluminium) is deposited on the top electrode of the capacitor. This conductive layer is usually delimited by an etching, typically to define an edge outside of a 3D support if one is used. This etching is usually a selective etching configured to stop after etching the top electrode layer on which the conductive layer has been deposited. Ideally, the etching process has no impact on the underlying dielectric or ionic conductor layer.

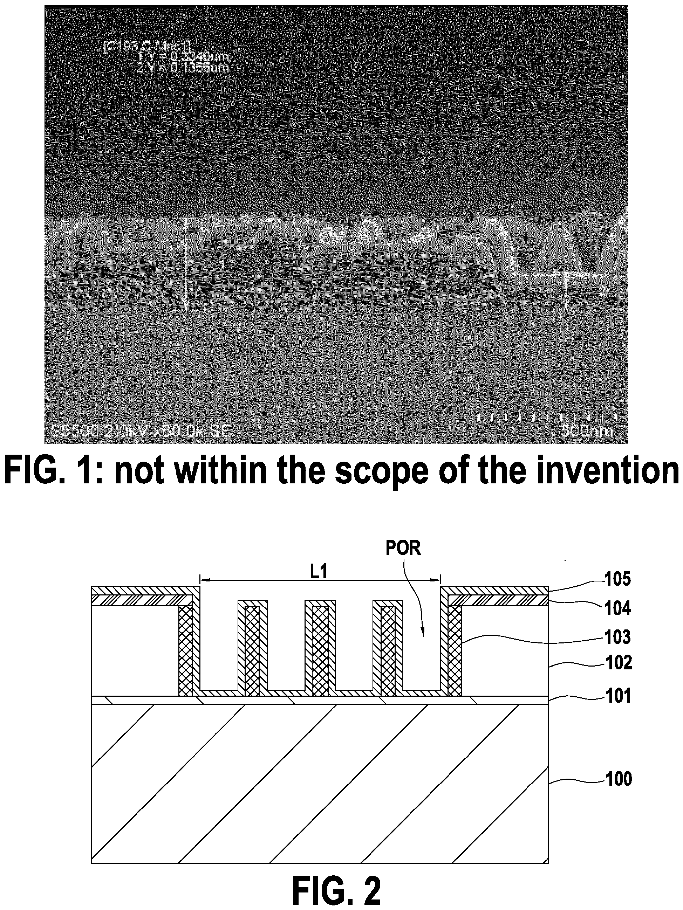

It has been observed, in particular when solid-state electrolytes such as LiPON are used, that the SF6 used to etch the top electrode (typically TiN) can react with the lithium within the LiPON layer and may lead to creating an irregular surface having the aspect of grass. Figure 1 is a SEM image of a such a damaged LiPON layer. Also, these structures have been observed to be LiF-based structures. This implies that the SF6 etching is barely selective, and not suitable for thin layers having a thickness of the order of less than 20nm (such a thickness being suitable for anodic porous oxide devices).

When the intermediate layer, for example comprising LiPON layer is damaged, the top and bottom electrode layers may be electrically shorted together, and other undesirable properties may be obtained.

There exists a need for a solution that prevents these undesirable effects from occurring, especially when using thin dielectric or thin ionic conductor layers (less than 20 nanometres).

The invention has been made in the light of the above problems.

### Summary of the Invention

The invention provides an integrated electrical device comprising an energy storage component, the component comprising, above a support, a bottom electrode layer, an intermediate layer comprising a dielectric layer or an ionic conductor (for example a solid-state electrolyte) layer above the bottom electrode layer, and a top electrode layer above the intermediate layer,
wherein the intermediate layer is in contact with the bottom electrode layer and with the top electrode layer in a central region, and the intermediate layer is spaced apart from either the bottom electrode layer or the top electrode layer by a buffer layer in a peripheral region that surrounds the central region, the buffer layer comprising an insulating material and being arranged on the bottom electrode layer (when the intermediate layer is spaced apart from the bottom electrode layer in the peripheral region) or on the intermediate layer (when the intermediate layer is spaced apart from the top electrode layer in the peripheral region), the buffer layer having an opening that opens onto the bottom electrode layer (when the intermediate layer is spaced apart from the bottom electrode layer in the peripheral region) or onto the intermediate layer (when the intermediate layer is spaced apart from the top electrode layer in the peripheral region) so as to define the central region,
the intermediate layer and the top electrode layer being arranged conformally above the bottom electrode layer (i.e. the intermediate layer is arranged conformally above and on the bottom electrode layer in the central region and the top electrode layer is arranged conformally above and on the intermediate layer in the central region - in the peripheral region, these layers are also conformal (i.e. deposited using a conformal deposition method) but may not be in contact with said layers because of the presence of the buffer layer).

The energy storage component is a capacitor or an ionic capacitor, comprising the bottom electrode layer, the intermediate layer, and the top electrode layer.

It should be noted that in the above device, the central region may also be referred to as the active region, as it is the region contributing the most to the capacitance of the capacitor or ionic capacitor.

By conformally, what is meant is that the intermediate layer follows the contours defined by the buffer layer and its opening (when the intermediate layer is spaced apart from the bottom electrode layer in the peripheral region). For example, the intermediate layer follows the contour of the walls of the buffer layer at the level of the edge of the opening. The top electrode layer also follows the contour of the intermediate layer. Alternatively, the intermediate layer follows the contours of the bottom electrode layer and the top electrode layer follows the contours defined by the buffer layer and its opening (when the intermediate layer is spaced apart from the top electrode layer in the peripheral region).

The support may be a planar support or a contoured support, for example a 3D support onto which the bottom electrode layer is arranged conformally.

Here, the buffer layer adds a thickness of material between the intermediate layer and the bottom electrode layer, or between the intermediate layer and the top electrode layer. Should the intermediate layer be damaged above the peripheral region (for example because of a subsequent etching step performed in the peripheral region), the presence of the buffer layer prevents a shorting between the top and the bottom electrode layer with the buffer layer on the bottom electrode layer. The thickness of the buffer layer may be selected accordingly to prevent this electrical shorting between the top and the bottom electrode layer at the level of the peripheral region. For cases where the buffer layer is on the intermediate layer, this configuration is advantageous when the bottom electrode material reacts during a subsequent etching or if the interface between the intermediate layer and the bottom electrode layer reacts during this subsequent etching (an electrical shorting is also avoided).

According to a particular embodiment, the device further comprises a conductive region arranged on the top electrode layer.

This conductive region can be a current collector of the component. For example, it comprises aluminium.

According to a particular embodiment, the device comprises a sidewall above the peripheral region, the sidewall being defined at least by an edge of the conductive region, and an edge of the top capacitor electrode layer.

When the intermediate layer is spaced apart from the bottom electrode layer in the peripheral region, the sidewall may also comprise an edge of the intermediate layer.

In this particular embodiment, the conductive material of the conductive region is etched/patterned for example in a photolithography step. This will define a sidewall in the device. This etching may also be configured to stop when the buffer layer is reached. When the buffer layer is reached, this implies that should the intermediate layer be damaged (when the intermediate layer is spaced apart from the bottom electrode layer in the peripheral region), this damaging occurs where the buffer layer is present to prevent a shorting between the top and bottom electrode layers.

According to a particular embodiment, the support comprises an anodic porous oxide region comprising a plurality of substantially straight pores that extend from a top surface of the anodic porous oxide region towards the bottom of the anodic porous oxide region, and wherein the central region encompasses a group of pores in which the stack formed by the bottom electrode layer, the intermediate layer, and the top electrode layer extends conformally on sidewalls and on the bottom of the pores of the group of pores of the anodic porous oxide region.

The central region encompassing a group of pores implies that when viewed from the top, the perimeter of the group of pores is within the opening.

For example, the group of pores may be defined by a hard mask (here part of the support) formed above an anodic porous oxide region which delimits the pores that will be used in the anodic porous oxide region to accommodate said stack. This hard mask may be formed in accordance with the method described in document EP 3567645.

According to a particular embodiment, the buffer layer has a thickness which is thicker than the intermediate layer.

The thickness of the buffer layer may be determined considering the selectivity of the chemistry used for the etching of the top electrode on the buffer layer material. In cases where the selectivity is very high, the thickness of the buffer layer can be reduced to few nanometres. In cases where the selectivity is null (1/1), the thickness of the buffer layer should increase with the following rule: the buffer layer thickness will be higher than the top electrode thickness considering the maximum thickness resulting from the non-uniformity across the wafer. Preferably double or triple this thickness and up to 5 times.

These thicknesses prevent any shorting from occurring between the top and the bottom electrode layer.

According to a particular embodiment, the buffer layer comprises an insulating material that differs from the material of the intermediate layer.

According to a particular embodiment, the insulating material of the buffer layer is selected from the group comprising SiO2, SiN, SiON, Al2O3, SiCOH.

The insulating material of the buffer layer may also be porous (i.e. a porous version of the materials of the above list).

Other suitable materials may be considered.

The invention also provides a method of manufacturing an integrated electrical device comprising an energy storage component, comprising:
forming, above a support, a bottom electrode layer,
forming, above the bottom electrode layer, an intermediate layer comprising a dielectric layer or an ionic conductor layer,
forming, above the intermediate layer, a top electrode layer,
wherein the intermediate layer is in contact with the bottom electrode layer and with the top electrode layer in a central region, and the intermediate layer is spaced apart from either the bottom electrode layer or the top electrode layer by a buffer layer formed in a peripheral region that surrounds the central region, the buffer layer comprising an insulating material and being arranged on the bottom electrode layer (when the intermediate layer is spaced apart from the bottom electrode layer in the peripheral region) or on the intermediate layer (when the intermediate layer is spaced apart from the top electrode layer in the peripheral region), the buffer layer having an opening that opens onto the bottom electrode layer (when the intermediate layer is spaced apart from the bottom electrode layer in the peripheral region) or onto the intermediate layer (when the intermediate layer is spaced apart from the top electrode layer in the peripheral region) so as to define the central region,
the intermediate layer and the top electrode layer being arranged conformally above the bottom electrode layer (i.e. the intermediate layer is arranged conformally above and on the bottom electrode layer in the central region and the top electrode layer is arranged conformally above and on the intermediate layer in the central region - in the peripheral region, these layers are also conformal (i.e. deposited using a conformal deposition method) but may not be in contact with said layers because of the presence of the buffer layer).

In the above method, the buffer layer is either formed on the intermediate layer or on the bottom electrode layer.

This method may be adapted for the manufacture of any embodiment of the device as defined above.

### Brief Description of the Drawings

Further features and advantages of the present invention will become apparent from the following description of certain embodiments thereof, given by way of illustration only, not limitation, with reference to the accompanying drawings in which:
- Figure 1, already described, is an image of a damaged LiPON layer,
- Figure 2 is a schematic representation of a support with a bottom electrode layer,
- Figure 3 shows the buffer layer formed on the device of figure 2,
- Figure 4 shows a conductive region formed on the device of figure 3,
- Figure 5 shows sidewalls being formed, and
- Figure 6 shows an additional conductive region formed on the device of figure 6.

### Detailed Description of Example Embodiments

We will now describe energy storage components such as capacitors and ionic capacitors, along with the methods and steps used to obtain these capacitors and ionic capacitors. In particular, we will describe the use of a buffer layer arranged on a bottom electrode layer. The invention is however not limited to this configuration and also applies to the use of a buffer layer arranged on an intermediate layer.

Figure 2 is an exemplary device comprising a substrate 100. This substrate can comprise a semiconductor region (typically silicon), or also glass or other materials. In particular, the substrate 100 can comprise a conductive layer at the level of its top surface.

Above this substrate, an anodization barrier layer 101 (tungsten, for example) has been deposited.

On the anodization barrier layer, a metal layer 102, typically comprising aluminium has been deposited. The material of this layer should be selected so as to allow forming straight pores that extend from the top surface of the metal layer to the anodization barrier layer.

Here, a portion of the metal layer has been anodized to obtain straight pores POR inside anodic porous oxide 103 that extend vertically on the figure so as to reach the anodization barrier layer. Alternatively, the entire metal layer can be anodized and only a subset of pores will be used to accommodate the subsequently described stack of layers. In the illustrated example, the substrate, the anodization barrier layer, and the anodic porous oxide form a support. This support is a contoured support, or 3D support. The invention is however not limited to 3D supports and may be implemented on planar supports.

On the support, a bottom electrode layer 105 has been deposited in a conformal manner (on the walls and on the bottom of the pores), for example by ALD. This layer may comprise TiN or other conductive materials.

It should be noted that the portion of the support which is contoured and which comprises a group of pores that accommodate the bottom electrode layer has a width L1 visible on the figure. This width may be defined using one or more hard masks, typically one hard mask delimiting an anodization region and one hard mask delimiting pores that are straight and vertical, as described in document EP 3567645. Also, forming the support can be done using the techniques described in document WO 2015/063420.

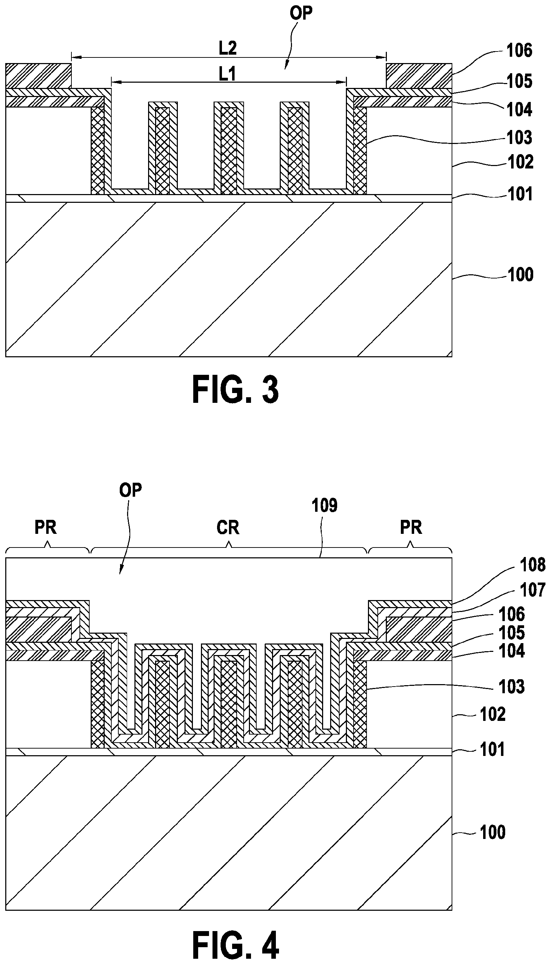

Figure 3 shows the structure of figure 2 after a buffer layer 106 has been deposited on the bottom electrode layer (for example in a non-conformal manner so as not to fill/penetrate the pores so as to facilitate complete removal of this layer where an opening will be formed)). This buffer layer may comprise an insulating material such as SiO2, SiN, SiON, Al2O3, SiCOH (other materials may also be considered). Also, the thickness of this buffer layer may be of the order of 50nm, typically n times thicker that the thickness of a subsequently deposited dielectric layer or ionic conductor layer (n being superior or equal to 2).

An opening OP has been formed in the buffer layer and this opening is a through opening that opens onto the bottom electrode layer. Also, the opening is dimensioned so as to include, when viewed from the top, the perimeter of the group of pores in which the bottom electrode layer is arranged. On the side-view of figure 3, the opening OP has a width L2 which is greater than the width L1 of the group of pores accommodating the bottom electrode layer.

In an alternative embodiment, L2 is smaller than L1 and the buffer layer covers a portion of pores. Preferably, in this alternative embodiment, the thickness of the buffer layer should be selected so as to ensure that the pores are plugged at their top opening when the buffer layer is deposited in a conformal manner (i.e. the material of the buffer layer does not penetrate the pores).

Figure 4 shows the structure of figure 3 after a plurality of conformal depositions have been carried out. An intermediate layer 106, here a dielectric layer or ionic conductor layer has been deposited in a conformal manner (for example by ALD). For example, this layer may comprise at least one material selected from the group including Si_{X}O_{Y}, AlₓO_{y}, HfₓO_{y}, ZrₓO_{y}, TiₓO_{y}, LiₓP_{y}O_{z}Nₓ₁, LiₓSi_{y}P_{z}Oₓ₁N_{y1}, NₓM'_{y}M"_{z}(Pₓ₁O_{y1})_{z}, with M' and M" being metals from the group comprising Al, Ti, Fe and N being an element from the group comprising Li, Na, K. A combination of these materials may also be considered for the intermediate layer.

The intermediate layer is spaced apart from the bottom electrode layer where the buffer layer is present in a region called peripheral region. This region surrounds a central region CR in which the intermediate layer is on (in contact) with the bottom electrode layer.

Also, as the intermediate layer is deposited in a conformal manner, it is deposited on the walls of the opening OP of the buffer layer, and on top of the buffer layer where it is present.

On the intermediate layer, a top electrode layer 108 has been deposited in a conformal manner. This top electrode layer may be analogous to the bottom electrode layer and it may also contain TiN.

In the central region CR, the stack formed by the bottom electrode layer, the intermediate layer, and the top electrode layer forms an energy storage component such as a capacitor or an ionic capacitor (depending on the material of the intermediate layer).

Above the top electrode layer, a conductive region 109 which may comprise aluminium has been deposited.

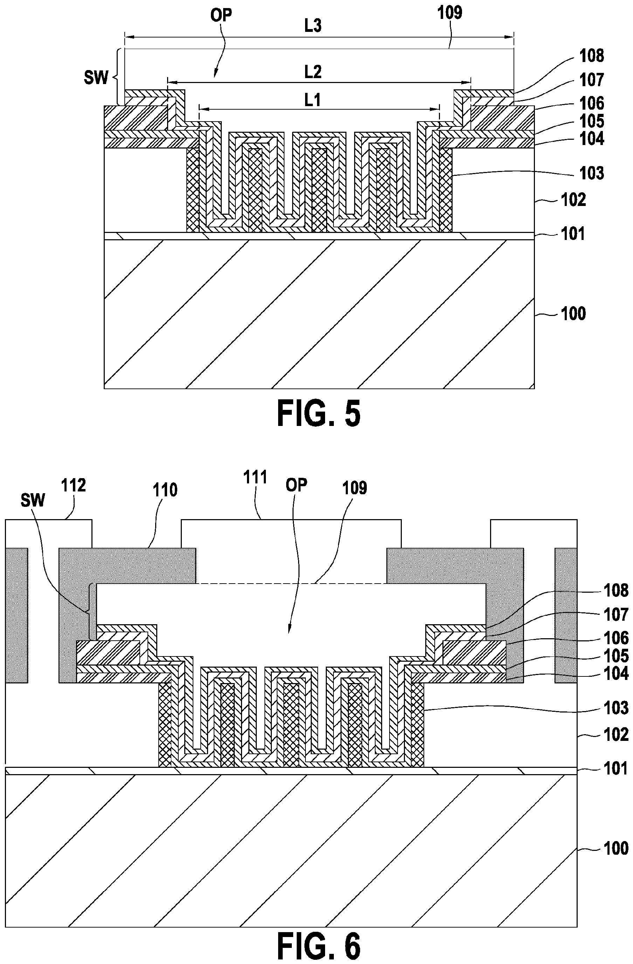

Figure 5 shows the structure of figure 4 in which sidewalls SW have been formed by etching the sides of the conductive region 109, the sides of the top electrode layer 108, and the sides of the intermediate layer 107. This etching can stop when the buffer layer is reached.

The sidewalls define a perimeter having a width L3 (with L3>L2>L1 - as explained above, in an alternative embodiment L2<L1; the width L3 is however greater than both L1 and L2) which, when viewed from the top, includes the perimeter defined by the opening. The perimeter defined by the opening includes the perimeter defined by the group of pores mentioned above.

Consequently, should the etching defining the sidewall damage the intermediate layer, this damaging may only penetrate the intermediate layer for a length which is smaller than the distance between the sidewall SW and the edge of the opening OP (i.e. the distance L3-L2). The width L3 can be selected in accordance with the length of the damage. This ensures that no shorting can occur between the bottom and top electrode layers.

Subsequently, and as shown on figure 6, an insulating region 110 can be formed to delimit electrical contacts that are filled with an additional conductive region 111 (typically aluminium) above and in contact with the conductive region 109. Also, the insulating region may have other openings filled with another additional conductive region 112 so as to contact the metal region 102 and the bottom electrode layer through the barrier layer 101. An electrical contact is therefore formed between the bottom electrode layer, the anodization barrier layer, the metal region, and this another additional conductive region 112.

In an alternative embodiment, not represented, the metal layer 102 has been completely anodized, and the bottom electrode layer is connected to the additional conductive region 112 through another porous region acting as a via comprising an electrically conductive material extending from the bottom to the top of the pores of this another porous region, also through the barrier layer 101.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. An integrated electrical device comprising an energy storage component, the component comprising, above a support (100, 101, 103), a bottom electrode layer (105), an intermediate layer (107) comprising a dielectric layer or an ionic conductor layer above the bottom electrode layer, and a top electrode layer (108) above and on the intermediate layer,
wherein the intermediate layer is in contact with the bottom electrode layer and with the top electrode layer in a central region (CR), and the intermediate layer is spaced apart from either the bottom electrode layer or the top electrode layer by a buffer layer (106) in a peripheral region (PR) that surrounds the central region, the buffer layer comprising an insulating material and being arranged on the bottom electrode layer or on the intermediate layer, the buffer layer having an opening that opens onto the bottom electrode layer or onto the intermediate layer so as to define the central region,
the intermediate layer and the top electrode layer being arranged conformally above the bottom electrode layer.

2. The device of claim 1, further comprising a conductive region arranged on the top electrode layer.

3. The device of claim 2, comprising a sidewall (SW) above the peripheral region, the sidewall being defined at least by an edge of the conductive region, and an edge of the top capacitor electrode layer.

4. The device of any one of claims 1 to 3, wherein the support comprises an anodic porous oxide region (103) comprising a plurality of substantially straight pores (POR) that extend from a top surface of the anodic porous oxide region towards the bottom of the anodic porous oxide region, and wherein the central region encompasses a group of pores in which the stack formed by the bottom electrode layer, the intermediate layer, and the top electrode layer extends conformally on sidewalls and on the bottom of the pores of the group of pores of the anodic porous oxide region.

5. The device of any one of claims 1 to 4, wherein the buffer layer has a thickness which is thicker than the intermediate layer.

6. The device of any one of claims 1 to 5, wherein the buffer layer comprises an insulating material that differs from the material of the intermediate layer.

7. The device of claim 6, wherein the insulating material of the buffer layer is selected from the group comprising SiO2, SiN, SiON, Al2O3, SiCOH.

8. A method of manufacturing an integrated electrical device comprising an energy storage component, comprising:
forming, above a support (100, 101, 103), a bottom electrode layer (105), forming, above the bottom electrode layer, an intermediate layer (107) comprising a dielectric layer or an ionic conductor layer,
forming, above the intermediate layer, a top electrode layer (108),
wherein the intermediate layer is in contact with the bottom electrode layer and with the top electrode layer in a central region, and the intermediate layer is spaced apart from either the bottom electrode layer or the top electrode layer by a buffer layer (106) formed in a peripheral region that surrounds the central region, the buffer layer comprising an insulating material and being arranged on the bottom electrode layer or on the intermediate layer, the buffer layer having an opening (OP)that opens onto the bottom electrode layer or onto the intermediate layer so as to define the central region,
the intermediate layer and the top electrode layer being arranged conformally above the bottom electrode layer.
